# EUROPÄISCHE PATENTSCHRIFT

(11) **EP 3 225 716 B1**
(45) Veröffentlichungstag und Bekanntmachung des Hinweises auf die Patenterteilung: **05.08.2020**
(21) Anmeldenummer: 16162982.9
(22) Anmeldetag: 30.03.2016
(51) Int. Cl.: C23C 14/02, C23C 16/02

(54) **VERFAHREN ZUR VORBEREITUNG EINES OBERFLÄCHENBEREICHS EINES SUBSTRATS FÜR EINE BESCHICHTUNG**
METHOD FOR PREPARING A SURFACE AREA OF A SUBSTRATE FOR A COATING
PROCEDE DE PREPARATION D'UNE ZONE DE SURFACE D'UN SUBSTRAT POUR UN REVETEMENT

(43) Veröffentlichungstag der Anmeldung: 04.10.2017
(73) Patentinhaber: Fraisa SA, 4512 Bellach (CH)
(72) Erfinder: Maushart, Josef, 4500 Solothurn (CH); Nägelin, Markus, 4537 Wiedlisbach (CH); Rechberger, Johann, 3068 Utzigen (CH)
(74) Vertreter: Keller & Partner Patentanwälte AG

(56) Entgegenhaltungen:
- JP-A- 2000 071 103
- CAPPELLI E ET AL: "Pulsed laser treatment of WC,Co tool substrates to improve Co removing and diamond nucleation", ADVANCES IN LASER ABLATION OF MATERIALS. SYMPOSIUM MATER. RES. SOC. WARRENDALE, PA, USA, 1998, Seiten 361-365, XP002760587, ISBN: 1-55899-432-7
- M. BARLETTA ET AL: "Chemical Vapor Deposition of Highly Adherent Diamond Coatings onto Co-Cemented Tungsten Carbides Irradiated by High Power Diode Laser", ACS APPLIED MATERIALS AND INTERFACES, Bd. 4, Nr. 2, 29. Dezember 2011 (2011-12-29), Seiten 694-701, XP055294021, US ISSN: 1944-8244, DOI: 10.1021/am2012992
- UHLMANN E ET AL: "Substrate pre-treatment of cemented carbides using abrasive flow machining and laser beam ablation", PRODUCTION ENGINEERING 2009 SPRINGER VERLAG DE, Bd. 3, Nr. 1, 2009, Seiten 81-86, XP002760588, DOI: 10.1007/S11740-008-0145-X
- Amélie Veillère ET AL: "Influence of WC-Co Substrate Pretreatment on Diamond Film Deposition by Laser-Assisted Combustion Synthesis", ACS applied materials & interfaces, vol. 3, no. 4, 4 April 2011 (2011-04-04), pages 1134-1139, XP055294019, US ISSN: 1944-8244, DOI: 10.1021/am101271b

## Beschreibung

### Technisches Gebiet

Die Erfindung betrifft ein Verfahren zur Vorbereitung eines Oberflächenbereichs eines Substrats für eine Beschichtung des Oberflächenbereichs des Substrats, wobei der Oberflächenbereich des Substrats aus Hartstoff besteht, wobei der Hartstoff einen metallischen Binder enthält.

### Stand der Technik

Verfahren zur Vorbereitung von Oberflächenbereichen von Substraten aus Hartstoff sind bekannt. Solche Verfahren sind beispielsweise in der FR 2 801 234 A1 (Jacques Gaillard) im Zusammenhang mit der Herstellung von Werkzeugen wie Bohrern oder Fräsern beschrieben. Die beschriebenen Werkzeuge sind aus einem Substrat aus Wolframkarbid hergestellt, wobei die Schneidkanten mit Diamant beschichtet sind. Bevor die Diamantbeschichtungen aufgetragen werden, sollte der Kobaltgehalt im Wolframkarbid auf unter 10% reduziert werden. Um dies zu erreichen, beschreibt die FR 2 801 234 A1 zwei Verfahren. Im ersten Verfahren wird das Kobalt im Wolframkarbid mittels Säure chemisch angegriffen. Dieses Vorgehen hat gemäss der FR 2 801 234 A1 jedoch den Nachteil, dass keine stark haltende Diamantbeschichtung ermöglicht wird. Im zweiten Verfahren hingegen werden in einem ersten Schritt mit einem Laserstrahl 2 µm bis 30 µm tiefe Alveolen in einem Abstand von 5 µm bis 40 µm im Substrat erzeugt. In einem zweiten Schritt des Verfahrens wird das Substrat mittels Mikrosandstrahlung behandelt, um die Schlacken der Laservorbehandlung zu entfernen. Und in einem dritten Schritt wird das Substrat mit Salzsäure oder Flusssäure behandelt, um alle Spuren von Kobalt auf der Oberfläche zu entfernen.

Das zweite in der FR 2 801 234 A1 beschriebene Verfahren ermöglicht zwar stärker haftende Beschichtungen des Substrats als das erste in der FR 2 801 234 A1 beschriebene Verfahren. Dennoch hat es den Nachteil, dass die Haftung der Beschichtung unzureichend ist.

CAPPELLI E ET AL: "Pulsed laser treatment of WC,Co tool substrates to improve Co removing and diamond nucleation", ADVANCES IN LASER ABLATION OF MATERIALS. SYMPOSIUM MATER. RES. SOC. WARRENDALE, PA, USA, 1998, Seiten 361-365, XP002760587, ISBN: 1-55899-432-7 offenbart ein Verfahren zur Vorbereitung eines Schneidwerkzeugs aus Hartmetall (WC-Co) für Beschichtung und anschließenden Diamantbeschichtung. Die Vorbereitung umfassend erst Abätzen das Kobalt mittels HNO₃/HF/H₂O und, in einem zweiten Schritt, Laserbehandlung der geätzten Substratoberfläche.

### Darstellung der Erfindung

Aufgabe der Erfindung ist es, ein dem eingangs genannten technischen Gebiet zugehörendes Verfahren zur Vorbereitung eines Oberflächenbereichs eines Substrats aus Hartstoff zu schaffen, welches die Beschichtung mit einer stark haftenden Schicht ermöglicht.

Die Lösung der Aufgabe ist durch die Merkmale des Anspruchs 1 definiert. Gemäss der Erfindung wird in einem ersten Schritt eine Oberfläche des Oberflächenbereichs des Substrats chemisch geätzt, um in einer Oberflächenzone des Oberflächenbereichs des Substrats einen Gewichtsanteil des metallischen Binders am Hartstoff zu reduzieren. Zudem wird in einem zweiten Schritt ein gepulster Laserstrahl über die Oberfläche des Oberflächenbereichs des Substrats geführt, um die Oberflächenzone des Oberflächenbereichs des Substrats zu festigen, wobei der gepulste Laserstrahl eine Pulsdauer von höchstens 20ps aufweist.

Durch das chemische Ätzen im ersten Schritt des Verfahrens wird der Gewichtsanteil des metallischen Binders am Hartstoff an der Oberfläche des Oberflächenbereichs des Substrats reduziert. Im Vergleich zur Oberfläche wird der Gewichtsanteil des metallischen Binders am Hartstoff mit zunehmender Tiefe in das Substrat hinein immer weniger stark reduziert. Somit weist der Oberflächenbereich des Substrats nach der Durchführung des ersten Schritts des Verfahrens ausgehend von seiner Oberfläche einen mit zunehmender Tiefe in das Substrat zunehmenden Gewichtsanteil an metallischem Binder auf. Daher ist die Oberflächenzone des Oberflächenbereichs des Substrats, in welcher der Gewichtsanteil des metallischen Binders am Hartstoff reduziert wird, die Zone, innerhalb von welcher der Gewichtsanteil des metallischen Binders nach der Durchführung des ersten Schritts des Verfahrens, in welchem die Oberfläche des Oberflächenbereichs des Substrats chemisch geätzt wird, auf mindestens 1/e, bzw. 36.79% des Gewichtsanteils des metallischen Binders vor der Durchführung des ersten Schritts des Verfahrens reduziert ist. Für die Bestimmung einer Tiefe, bis in welche die Oberflächenzone ausgehend von der Oberfläche des Substrats in das Substrat hinein reicht, ist daher nach der Durchführung des ersten Schritts des Verfahrens in Abhängigkeit der Tiefe der durchschnittliche Gewichtsanteil des metallischen Binders innerhalb eines in der jeweiligen Tiefe im Substrat parallel zu Oberfläche des Substrats verlaufenden, flächenartigen Volumens mit infinitesimal geringer Ausdehnung senkrecht zur Oberfläche des Substrats zu bestimmen. Das derart bestimmte Tiefenprofil des Gewichtsanteils des metallischen Binders kann mit einem vor der Durchführung des ersten Schritts des Verfahrens bestimmten Tiefenprofil des Gewichtsanteils des metallischen Binders verglichen werden. Unter der Voraussetzung, dass der durchschnittliche Gewichtsanteil des metallischen Binders vor der Durchführung des ersten Schritts in jeder Tiefe im relevanten Bereich des Substrats gleich war, genügt aber auch der Vergleich des nach der Durchführung des ersten Schritts des Verfahrens bestimmten Tiefenprofils des Gewichtsanteils des metallischen Binders mit dem durchschnittlichen Gewichtsanteils des metallischen Binders im relevanten Bereich des Substrats, welcher vor der Durchführung des ersten Schritts bestimmt wurde. Falls ein vom Substrat separates Stück aus dem gleichen Hartstoff mit metallischem Binder wie der relevante Bereich des Substrats vorhanden ist, kann das nach der Durchführung des ersten Schritts des Verfahrens bestimmte Tiefenprofil des Gewichtsanteils des metallischen Binders auch mit dem durchschnittlichen Gewichtsanteil des metallischen Binders in diesem separaten, nicht mit dem ersten Schritt des Verfahrens behandelten Stück, verglichen werden.

Wie eingangs bereits erwähnt, betrifft das erfindungsgemässe Verfahren die Vorbereitung eines Oberflächenbereichs eines Substrats, welches aus Hartstoff mit metallischem Binder besteht. Das bedeutet, dass der Oberflächenbereich des Substrats aus einem Hartstoff besteht, welcher aus einer Hartstoffphase und einem metallischen Binder besteht. Zudem kann der Hartstoff aber auch einen geringfügigen Anteil an Verunreinigungen enthalten. Der Anteil an Hartstoff mit metallischem Binder in der Oberflächenzone des Oberflächenbereichs macht jedoch bevorzugt mindestens 95 Gewichtsprozent, besonders bevorzug mindestens 98 Gewichtsprozent und ganz besonders bevorzugt mindestens 99 Gewichtsprozent aus. Diese Angabe in Gewichtsprozent bezieht sich auf den prozentualen Gewichtsanteil des Hartstoffs mit metallischem Binder an der gesamten Masse innerhalb eines Volumens, welches an der Oberfläche des Oberflächenbereichs eine Fläche von mindestens 0.1mm² einnimmt und von der Oberfläche des Oberflächenbereichs über die gesamte Tiefe der Oberflächenzone in das Substrat hinein reicht. Dabei ist unerheblich, ob der Hartstoff mit metallischem Binder innerhalb dieses Volumens gleichmässig verteilt ist oder nicht.

Unabhängig davon weist der Hartstoff bevorzugt eine Struktur mit Körnern aus Hartstoffphase auf, welche durch den metallischen Binder zusammengehalten sind. Dabei befindet sich der metallische Binder vorwiegend an den Korngrenzen und bindet die Körner zusammen. Daher ist der Gewichtsanteil des metallischen Binders am Hartstoff als Mittelwert des Gewichtsanteils des metallischen Binders an der Masse des Substrats zu verstehen. Daher ist der Gewichtsanteil des metallischen Binders am Hartstoff in der Oberflächenzone des Oberflächenbereichs des Substrats der prozentuale Gewichtsanteil des metallischen Binders an der gesamten Masse des Substrats innerhalb eines Volumens, welches an der Oberfläche des Oberflächenbereichs eine Fläche von mindestens 0.1mm² einnimmt und von der Oberfläche des Oberflächenbereichs über die gesamte Tiefe der Oberflächenzone in das Substrat hinein reicht. Dabei ist unerheblich, ob der metallische Binder innerhalb dieses Volumens gleichmässig verteilt ist oder nicht. Der Gewichtsanteil des metallischen Binders am Hartstoff kann aber auch in Abhängigkeit der Tiefe in der Oberflächenzone des Oberflächenbereichs des Substrats angegeben werden. In diesem Fall ist der Gewichtsanteil des metallischen Binders am Hartstoff der durchschnittliche Gewichtsanteil des metallischen Binders an der Masse innerhalb eines in dieser Tiefe im Substrat parallel zur Oberfläche des Substrats verlaufenden, flächenartigen Volumens mit infinitesimal geringer Ausdehnung senkrecht zur Oberfläche des Substrats.

Indem, gemäss der erfindungsgemässen Lösung, im ersten Schritt der Gewichtsanteil des metallischen Binders am Hartstoff in der Oberflächenzone des Oberflächenbereichs des Substrats durch chemisches Ätzen reduziert wird, wird die Struktur des Hartstoffs in der Oberflächenzone verändert. Dabei wird insbesondere zwischen den Körnern aus Hartstoffphase angeordneter metallischer Binder entfernt oder zumindest reduziert. Dadurch verbleibt eine körnige, poröse Gerüststruktur. Indem im zweiten Schritt der Laserstrahl über die Oberfläche des Oberflächenbereichs des Substrats geführt wird, um die Oberflächenzone des Oberflächenbereichs des Substrats zu festigen, wird die körnige, poröse Gerüststruktur in der Oberflächenzone gefestigt. Dabei bleibt aber eine teilweise verschweisste Gerüststruktur bestehen. Das bedeutet, dass während der Laserbehandlung die Oberflächenzone des Oberflächenbereichs des Substrats nicht gänzlich aufgeschmolzen wird und dass es somit auch nicht zu einer Verglasung der Oberflächenzone kommt. Vielmehr wird durch die Laserbehandlung einzig der Zusammenhalt der körnigen Gerüststruktur erhöht. Dieser Vorgang kann auch als Gerüstverstärkung oder als Verkrustung der Oberflächenzone bezeichnet werden.

Eine derartig gefestigte Gerüststruktur in der Oberflächenzone des Oberflächenbereichs des Substrats hat den Vorteil, dass sie die Auftragung einer stärker haftenden Beschichtung erlaubt.

Vorzugsweise reicht die Oberflächenzone von der Oberfläche des Oberflächenbereichs des Substrats bis etwa 30µm, bevorzugt bis etwa 20µm, besonders bevorzugt bis etwa 10µm tief in das Substrat. Diese Ausdehnung der Oberflächenzone hat den Vorteil, dass eine optimale Vorbereitung des Oberflächenbereichs des Substrats gewährleistet wird, sodass eine stärker haftende Beschichtung aufgebracht werden kann.

Alternativ dazu besteht aber auch die Möglichkeit, dass die Oberflächenzone von der Oberfläche des Oberflächenbereichs des Substrats bis tiefer als etwa 30µm in das Substrat hinein reicht.

Vorteilhafterweise weist der Hartstoff vor der Durchführung des ersten Schritts in der Oberflächenzone des Oberflächenbereichs des Substrats Körner aus Hartstoffphase mit einer Korngrösse von etwa 0.2µm bis 3.0µm, bevorzugt von etwa 0.2µm bis 2.0µm, besonders bevorzugt von etwa 0.2µm bis 1.0µm auf, welche durch den metallischen Binder miteinander verbunden sind. Dies hat den Vorteil, dass der Hartstoff kostengünstig bereitgestellt werden kann und dass mit dem Verfahren der Oberflächenbereich des Substrats für eine besonders gut haftende Beschichtung vorbereitet werden kann.

Alternativ dazu besteht aber auch die Möglichkeit, dass der Hartstoff vor der Durchführung des ersten Schritts in der Oberflächenzone des Oberflächenbereichs des Substrats Körner aus Hartstoffphase mit einer anderen Korngrösse aufweist, welche durch den metallischen Binder miteinander verbunden sind. Beispielsweise kann die Korngrösse auch kleiner als 0.2µm sein. Derart kleine Körner haben den Vorteil, dass eine höhere Härte des Hartstoffs erreicht wird. Die vorgenannten Werte beziehen sich auf Korngrössen, welche nach der Norm ISO 4499-2:2008 gemessen wurden.

Bevorzugt liegt vor der Durchführung des ersten Schritts der Gewichtsanteil des metallischen Binders am Hartstoff in der Oberflächenzone des Oberflächenbereichs des Substrats in einem Bereich von 5 bis 20 Gewichtsprozent des Hartstoffs, besonders bevorzugt in einem Bereich von 5 bis 15 Gewichtsprozent des Hartstoffs und ganz besonders bevorzugt in einem Bereich von 6 bis 12 Gewichtsprozent des Hartstoffs. Dies hat den Vorteil, dass das Substrat mit dem Oberflächenbereich aus Hartstoff vergleichsweise kostengünstig hergestellt werden kann.

Alternativ dazu besteht aber auch die Möglichkeit, dass der Gewichtsanteil des metallischen Binders am Hartstoff in der Oberflächenzone vor der Durchführung des ersten Schritts des Verfahrens in einem anderen Bereich liegt.

Vorzugsweise wird durch die Durchführung des ersten Schritts der Gewichtsanteil des metallischen Binders am Hartstoff im Drittel der Oberflächenzone des Oberflächenbereichs des Substrats, welcher der Oberfläche des Oberflächenbereichs am nächsten liegt, auf weniger als 1 Gewichtsprozent des Hartstoffs, bevorzugt auf weniger als 0.5 Gewichtsprozent des Hartstoffs, besonders bevorzugt auf weniger als 0.1 Gewichtsprozent des Hartstoffs reduziert. Dabei reicht der Drittel der Oberflächenzone des Oberflächenbereichs des Substrats, welcher der Oberfläche des Oberflächenbereichs am nächsten liegt, von der Oberfläche des Oberflächenbereichs des Substrats bis einen Drittel der Tiefe, bis in welche die Oberflächenzone ausgehend von der Oberfläche des Substrats in das Substrat hinein reicht, in das Substrat hinein. Diese Reduktion des Gewichtsanteils des metallischen Binders am Hartstoff hat den Vorteil, dass der Oberflächenbereich des Substrats für besonders gut haftende Beschichtungen vorbereitet wird.

Alternativ dazu besteht aber auch die Möglichkeit, dass der Gewichtsanteil des metallischen Binders am Hartstoff im Drittel der Oberflächenzone des Oberflächenbereichs des Substrats, welcher der Oberfläche des Oberflächenbereichs am nächsten liegt, durch die Durchführung des ersten Schritts des Verfahrens weniger stark reduziert wird.

Vorzugsweise ist der Hartstoff ein Hartmetall oder ein Cermet. Dabei enthält das Hartmetall bzw. das Cermet eine Hartstoffphase sowie einen metallischen Binder. Hartmetall hat den Vorteil, dass es sehr verschleissfest ist, während Cermet den Vorteil hat, dass ein daraus hergestelltes Produkt wie beispielsweise ein spanabtragendes Werkzeug auch bei sehr hohen Temperaturen beständig ist.

Falls der Hartstoff ein Hartmetall ist, so ist die Hartstoffphase des Hartmetalls vorzugsweise Wolframkarbid (WC), Titankarbid (TiC) oder Titannitrid (TiN). Dies hat den Vorteil, dass das Material für den Oberflächenbereich des Substrats kostengünstig herstellbar ist. In einer Variante dazu besteht aber auch die Möglichkeit, dass die Hartstoffphase des Hartmetalls weder Wolframkarbid (WC), Titankarbid (TiC) noch Titannitrid (TiN) ist. So kann die Hartstoffphase beispielsweise auch Tantalkarbid (TaC), Vanadiumkarbid (VC) oder Chromkarbid (Cr₃C₂) sein. Sie kann aber beispielsweise auch ein anderes Metallkarbid sein.

Falls der Hartstoff ein Cermet ist, so ist die Hartstoffphase des Cermets vorzugsweise ein Karbonitrid. Beispielsweise kann es sich dabei um Titankarbonitrid (TiCₓN_{y}), Molybdänkarbonitrid (MoCₓN_{y}), Wolframkarbonitrid (WCₓN_{y}) oder Tantalkarbonitrid (TaCₓN_{y}) handeln. Der Wert von X und Y, welche in den vorgängig genannten chemischen Formeln den Kohlenstoffanteil bzw. den Stickstoffanteil an den Karbonitriden angeben, ist dabei unerheblich, da der Kohlenstoffanteil sowie der Stickstoffanteil an den Karbonitriden unerheblich ist.

Alternativ dazu besteht aber auch die Möglichkeit, dass der Hartstoff ein anderes Material als ein Hartmetall oder ein Cermet ist.

Falls der Hartstoff ein Hartmetall mit Wolframkarbid als Hartstoffphase ist, so weist die Hartstoffphase nebst Wolframkarbid bevorzugt Titankarbid, Tantalkarbid, Chromcarbid, Molybdänkarbid oder Vanadiumkarbid als Additiv auf. Eines oder mehrere solcher Additive machen vorzugsweise höchstens 10 Gewichtsprozent, besonders bevorzugt höchstens 5 Gewichtsprozent der Hartstoffphase aus. Solche Additive können aber auch mehr als 10 Gewichtsprozent der Hartstoffphase ausmachen. Je nach Anwendungszweck des mit dem Verfahren für eine Beschichtung vorzubereitenden Substrats, können solche Additive vorteilhaft sein. Titankarbid und Tantalkarbid als Additiv haben beispielsweise den Vorteil, dass das Hartmetall bei höheren Temperaturen eine grössere Härte behält. Falls mit dem Verfahren Bereiche eines Substrats für eine Beschichtung zur Herstellung von spanabtragenden Werkzeugen wie beispielsweise Bohrern oder Fräsern vorbereitet werden sollen, sind daher Titankarbid und Tantalkarbid als Additive beispielsweise für Werkzeuge zur Bearbeitung von langspanenden Werkstoffen wie zum Beispiel Stahl, Stahlguss oder langspanenden Temperguss geeignet.

Alternativ dazu kann das Wolframkarbid aber auch keines dieser Additive aufweisen.

Unabhängig davon, ob der Hartstoff ein Hartmetall, ein Cermet oder ein anderes Material ist, ist der metallische Binder vorteilhafterweise Kobalt, eine Kobaltlegierung, Nickel, eine Nickellegierung, Molybdän, eine Molybdänlegierung, Eisen oder eine Eisenlegierung. Je nach Anwendungszweck des mit dem Verfahren für eine Beschichtung vorzubereitenden Substrats können diese metallischen Binder vorteilhaft sein.

Alternativ dazu kann der metallische Binder aber auch weder Kobalt, eine Kobaltlegierung, Nickel, eine Nickellegierung, Molybdän, eine Molybdänlegierung, Eisen noch eine Eisenlegierung sein.

Falls der Hartstoff ein Hartmetall mit Wolframkarbid als Hartstoffphase ist, ist der metallische Binder vorzugsweise Kobalt oder eine Kobaltlegierung. Falls der Hartstoff hingegen ein Hartmetall mit Titankarbid als Hartstoffphase ist, so ist der metallische Binder bevorzugt Kobalt, eine Kobaltlegierung, Nickel, eine Nickellegierung, Molybdän oder eine Molybdänlegierung. Falls der Hartstoff jedoch ein Hartmetall mit Titannitrid als Hartstoffphase ist, so ist der metallische Binder bevorzugt Kobalt, eine Kobaltlegierung, Nickel, eine Nickellegierung, Molybdän oder eine Molybdänlegierung.

Alternativ dazu können zu Wolframkarbid, Titankarbid und Titannitrid als Hartstoffphase aber auch andere metallische Binder wie beispielsweise Eisen oder eine Eisenlegierung verwendet werden.

Bevorzugt ist das gesamte Substrat aus Hartstoff mit metallischem Binder. Dies hat den Vorteil, dass das Substrat eine grosse Festigkeit und Stabilität aufweist.

In einer bevorzugten Variante dazu besteht hingegen nur der Oberflächenbereich des Substrats im Bereich der Oberflächenzone oder allenfalls etwas weiter als die Oberflächenzone in das Substrat hineinreichend aus Hartstoff. Eine solche Variante hat den Vorteil, dass das Substrat mit weniger Gewicht und damit leichter konstruiert werden kann.

Bevorzugt wird im ersten Schritt des Verfahrens die Oberfläche des Oberflächenbereichs des Substrats mit einer Lauge behandelt. Dies hat den Vorteil, dass in der Oberflächenzone des Oberflächenbereichs des Substrats die der Oberfläche am nächsten liegenden Körner aus dem metallischen Binder gelöst werden. Vorzugsweise enthält die Lauge dabei wenigstens eine der Substanzen Kaliumhydroxid (KOH) und Kaliumhexacyanidoferrat(III) (K₃[Fe(CN)₆]). Besonders bevorzugt enthält die Lauge auf zehn Gewichtsanteile Wasser (H₂O) etwa einen Gewichtsanteil Kaliumhydroxid (KOH) und etwa einen Gewichtsanteil Kaliumhexacyanidoferrat(III) (K₃[Fe(CN)₆]). Dies hat den Vorteil, dass in der Oberflächenzone des Oberflächenbereichs des Substrats die der Oberfläche am nächsten liegenden Körner besonders effektiv aus dem metallischen Binder gelöst werden können. Es besteht aber auch die Möglichkeit, dass die Lauge eine andere Zusammensetzung mit anderen oder keinen Anteilen von Kaliumhydroxid (KOH) und Kaliumhexacyanidoferrat(III) (K₃[Fe(CN)₆]) aufweist. Zudem besteht die Möglichkeit, dass die Lauge andere Substanzen enthält.

Alternativ dazu besteht aber auch die Möglichkeit, dass im ersten Schritt des Verfahrens die Oberfläche des Oberflächenbereichs des Substrats nicht mit einer Lauge behandelt wird.

Vorteilhafterweise wird im ersten Schritt des Verfahrens die Oberfläche des Oberflächenbereichs des Substrats mit einer Säure behandelt. Dies hat den Vorteil, dass in der Oberflächenzone des Oberflächenbereichs des Substrats der Gewichtsanteil des metallischen Binders am Hartstoff effektiv reduziert wird. Vorzugsweise enthält die Säure dabei wenigstens eine der Substanzen Chlorwasserstoff (HCl), Fluorwasserstoff (HF), Wasserstoffperoxid (H₂O₂) und Dihydrogensulfat (H₂SO₄). Besonders bevorzugt enthält die Säure auf zehn Volumenanteile Wasserstoffperoxid (H₂O₂) etwa einen Volumenanteil Dihydrogensulfat (H₂SO₄), wobei der Wasseranteil der Säure frei wählbar ist. Dies hat den Vorteil, dass im ersten Schritt des Verfahrens der Gewichtsanteil des metallischen Binders am Hartstoff effektiv reduziert werden kann. Je weniger Wasseranteile die Säure dabei hat, desto rascher kann der Gewichtsanteil des metallischen Binders am Hartstoff reduziert werden. Es besteht aber auch die Möglichkeit, dass die Säure eine andere Zusammensetzung mit anderen oder keinen Volumenanteilen Wasserstoffperoxid (H₂O₂) und Dihydrogensulfat (H₂SO₄) sowie mit oder ohne Volumenanteilen Chlorwasserstoff (HCl) oder Fluorwasserstoff (HF) aufweist. Zudem besteht die Möglichkeit, dass die Säure andere Substanzen enthält.

Alternativ dazu besteht aber auch die Möglichkeit, dass im ersten Schritt des Verfahrens die Oberfläche des Oberflächenbereichs des Substrats nicht mit einer Säure behandelt wird.

Vorteilhafterweise wird im ersten Schritt des Verfahrens die Oberfläche des Oberflächenbereichs des Substrats zuerst mit Lauge und danach mit Säure behandelt. Dies hat den Vorteil, dass zuerst mit der Lauge aus dem Oberflächenbereich des Substrats Körner aus Hartstoffphase aus dem metallischen Binder gelöst werden können und dass danach aufgrund der Vorbehandlung mit Lauge mit der Säure in der Oberflächenzone des Oberflächenbereichs des Substrats der Gewichtsanteil des metallischen Binders am Hartstoff besonders effektiv reduziert werden kann. Diese Vorteile sind besonders ausgeprägt, wenn eine Lauge mit etwa einem Gewichtsanteil Kaliumhydroxid (KOH) und etwa einem Gewichtsanteil Kaliumhexacyanidoferrat(III) (K₃[Fe(CN)₆]) auf zehn Gewichtsanteile Wasser (H₂O) und eine Säure mit etwa zehn Volumenanteilen Wasserstoffperoxid (H₂O₂) auf etwa einen Volumenanteil Dihydrogensulfat (H₂SO₄) bei frei wählbarem Wasseranteil verwendet wird. Es besteht jedoch auch die Möglichkeit, dass eine andere Lauge, eine andere Säure oder sowohl eine andere Lauge als auch eine andere Säure verwendet wird. Unabhängig von der verwendeten Lauge und der verwendeten Säure wird vorzugsweise nach der Behandlung mit Lauge und vor der Behandlung mit Säure der Oberflächenbereich des Substrats mit Wasser (H₂O) abgespült und getrocknet. Dies hat den Vorteil, dass unerwünschte Reaktionen der Säure mit der Lauge verhindert oder zumindest reduziert werden können. Es besteht aber auch die Möglichkeit, dass auf diesen Zwischenschritt des Abspülens und Trocknens verzichtet wird.

Alternativ dazu besteht aber auch die Möglichkeit, dass für das chemische Ätzen der Oberfläche des Oberflächenbereichs des Substrats eine andere Substanz als eine Lauge oder eine Säure verwendet wird.

Bevorzugt ist der im zweiten Schritt verwendete Laserstrahl ein gepulster Laserstrahl. Dies hat den Vorteil, dass bei einer bestimmten mittleren Leistung des Laserstrahls während der Dauer eines Pulses eine grössere Energie an der Oberfläche des Oberflächenbereichs des Substrats deponiert werden kann als bei einem kontinuierlichen Laser mit gleicher mittlerer Leistung. Dadurch kann die Oberflächenzone des Oberflächenbereichs des Substrats besser gefestigt werden.

Alternativ dazu besteht aber auch die Möglichkeit, dass der im zweiten Schritt verwendete Laserstrahl ein kontinuierlicher Laserstrahl ist.

Vorzugsweise wird für die Erzeugung des Laserstrahls ein Dioden-gepumpter Festkörperlaser verwendet. Vorteilhafterweise weist dabei der Festkörperlaser einen Laserkristall mit Neodym als aktives Element auf. Besonders bevorzugt ist der Laserkristall Neodym dotiertes Yttrium-Vanadat (Nd:YVO₄). Es besteht aber auch die Möglichkeit, dass der Festkörperlaser einen Laserkristall aus einem anderen Material aufweist. Alternativ dazu kann für die Erzeugung des Laserstrahls aber auch ein anderer Festkörperlaser oder ein anderer Laser als ein Festkörperlaser verwendet werden.

Bevorzugt weist der im zweiten Schritt verwendete Laserstrahl eine Wellenlänge im Bereich von 900 nm bis 1'200 nm auf. Besonders bevorzugt weist der im zweiten Schritt verwendete Laserstrahl eine Wellenlänge von 1064 nm auf. Alternativ dazu besteht aber auch die Möglichkeit, dass der Laserstrahl eine Wellenlänge aufweist, welche kleiner als 900 nm oder grösser als 1'200 nm ist.

Vorzugsweise ist der Laserstrahl ein gepulster Laserstrahl mit einer Pulsdauer von höchstens 15ps, besonders bevorzugt höchstens 14ps. Dies hat den Vorteil, dass die Oberflächenzone des Oberflächenbereichs des Substrats optimal gefestigt werden kann, ohne dabei der Hartstoff gänzlich aufzuschmelzen und zu verglasen.

Alternativ dazu besteht aber auch die Möglichkeit, dass der Laserstrahl ein gepulster Laserstrahl mit einer Pulsdauer von mehr als 20ps ist.

Bevorzugt ist die Pulsdauer des gepulsten Laserstrahls mindestens 1ps, besonders bevorzugt mindestens 10ps, ganz besonders bevorzugt mindestens 11ps. Dies hat den Vorteil, dass die Oberflächenzone des Oberflächenbereichs des Substrats optimal gefestigt werden kann, ohne dabei der Hartstoff gänzlich aufzuschmelzen und zu verglasen.

Alternativ dazu besteht aber auch die Möglichkeit, dass der Laserstrahl ein gepulster Laserstrahl mit einer Pulsdauer von 10ps oder weniger ist.

Bevorzugt liegt die Pulsdauer des gepulsten Laserstrahls im Bereich von 10ps bis 20ps, besonders bevorzugt im Bereich von 10ps bis 15ps, ganz besonders bevorzugt im Bereich von 11ps bis 14ps. Dies hat den Vorteil, dass die Oberflächenzone des Oberflächenbereichs des Substrats optimal gefestigt werden kann, ohne dabei das Hartstoff gänzlich aufzuschmelzen und zu verglasen.

Alternativ dazu besteht aber auch die Möglichkeit, dass der Laserstrahl ein gepulster Laserstrahl mit einer Pulsdauer in einem anderen Bereich ist.

Im Falle eines gepulsten Laserstrahls werden die Laserpulse vorzugsweise in zeitlich regelmässigen Häufungen, welche zeitlich voneinander beabstandet sind, abgegeben. Dabei ist ein zeitlicher Abstand zwischen zwei aufeinanderfolgenden Laserpulsen innerhalb einer Häufung vorzugsweise kleiner als ein zeitlicher Abstand zwischen einem letzten Laserpuls einer Häufung und einem ersten Laserpuls der nächstnachfolgenden Häufung. Durch die Häufungen der Laserpulse können die einzelnen Laserpulse eine geringere Energie aufweisen, um den gleichen Effekt zu erzielen wie wenn ein gepulster Laserstrahl ohne Häufungen der Laserpulse verwendet würde. Dabei entspricht die Anzahl Laserpulse pro Häufung etwa dem Faktor, um welchen die Energie der einzelnen Laserpulse reduziert werden kann.

Besonders bevorzugt beginnen die einzelnen Laserpulse innerhalb der Häufungen in einem zeitlichen Abstand im Bereich von 5 ns bis 50 ns, ganz besonders bevorzugt im Bereich von 10 ns bis 25 ns. Die Abstände zwischen den einzelnen Laserpulse innerhalb der Häufungen können aber auch grösser oder kleiner sein. Weiter beginnen die Häufungen vorzugsweise in einem zeitlichen Abstand, welcher grösser als 1 µs ist. Vorzugsweise umfassen die Häufungen jeweils eine Anzahl Laserpulse im Bereich von 4 bis 10 Laserpulsen, besonders bevorzugt im Bereich von 6 bis 8 Laserpulsen. Es besteht aber auch die Möglichkeit, dass die Häufungen eine grössere oder kleinere Anzahl Laserpulse umfassen.

Alternativ dazu besteht auch die Möglichkeit, dass die Laserpulse nicht in zeitlich regelmässigen Häufungen, sondern in gleichen Abständen zueinander abgegeben werden.

Vorteilhafterweise ist der Laserstrahl ein gepulster Laserstrahl mit einer Pulsfrequenz im Bereich von 100kHz bis 2'000kHz, bevorzugt im Bereich von 400kHz bis 1'600kHz, besonders bevorzugt im Bereich von 800kHz bis 1'200kHz. Wenn dabei die Laserpulse in zeitlich regelmässigen Häufungen, welche zeitlich voneinander beabstandet sind, abgegeben werden, handelt es sich bei dieser Pulsfrequenzangabe um die Frequenz der Häufungen und nicht um die Frequenz der einzelnen Pulse. Unabhängig davon haben die angegebenen Bereiche der Pulsfrequenz den Vorteil, dass eine rasche Durchführung des Verfahrens ermöglicht wird.

Als Variante dazu besteht auch die Möglichkeit, dass der gepulste Laserstrahl eine Pulsfrequenz in einem anderen Bereich aufweist oder dass der gepulste Laserstrahl eine sich zeitlich ändernde Pulsfrequenz aufweist.

Alternativ zu einem gepulsten Laserstrahl besteht aber auch die Möglichkeit, dass der Laserstrahl ein kontinuierlicher Laserstrahl ist.

Bevorzugt weist der Laserstrahl eine mittlere Leistung im Bereich von 1 Watt bis 20 Watt, besonders bevorzugt im Bereich von 5 Watt bis 10 Watt auf. Im Falle eines gepulsten Laserstrahls ist die mittlere Leistung des Laserstrahls die über mehrere Pulse gemessene Leistung des Laserstrahls. Falls der Laserstrahl dabei ein kontinuierlicher Laserstrahl ist, so handelt es sich um die mittlere Leistung des Laserstrahls. Falls der Laserstrahl dabei hingegen ein gepulster Laserstrahl ist, so handelt es sich bei der Leistung um die über mehrere Laserpulse und allenfalls mehrere Häufungen von Laserpulsen gemittelte Leistung des Laserstrahls. Der Leistungsbereich des Laserstrahls im Bereich von 1 Watt bis 20 Watt, bzw. von 5 Watt bis 10 Watt, hat den Vorteil, dass die Oberflächenzone des Oberflächenbereichs des Substrats gut gefestigt werden kann.

Alternativ dazu besteht aber auch die Möglichkeit, dass die mittlere Leistung des Laserstrahls weniger als 1 Watt oder mehr als 20 Watt betragen kann.

Bevorzugt wird im zweiten Schritt des Verfahrens der Laserstrahl mit einem Fokuspunkt mit einem Durchmesser im Bereich vom 30 µm bis 40 µm über den Oberflächenbereich des Substrats geführt. Dies hat den Vorteil, dass eine optimale Balance zwischen einer möglichst grossen Energiedichte im Fokuspunkt des Laserstrahls und einer möglichst grossen, durch den Laserstrahl abgedeckten Fläche erreicht werden kann.

Alternativ dazu kann im zweiten Schritt des Verfahrens der Laserstrahl auch mit einem Fokuspunkt mit einem grösseren oder kleineren Durchmesser über den Oberflächenbereich des Substrats geführt werden.

Bevorzugt ist der Laserstrahl im zweiten Schritt des Verfahrens an der Stelle, an welcher der Laserstrahl auf die Oberfläche des Oberflächenbereichs des Substrats auftrifft, senkrecht zur Oberfläche des Oberflächenbereichs des Substrats ausgerichtet. Dies hat den Vorteil, dass die Oberflächenzone des Oberflächenbereichs des Substrats auf kontrollierte Art und Weise gefestigt werden kann.

Alternativ dazu besteht aber auch die Möglichkeit, dass der Laserstrahl im zweiten Schritt des Verfahrens an der Stelle, an welcher der Laserstrahl auf die Oberfläche des Oberflächenbereichs des Substrats auftrifft, anders zur Oberfläche des Oberflächenbereichs des Substrats ausgerichtet ist.

Vorzugsweise wird im zweiten Schritt des Verfahrens der Laserstrahl entlang von nebeneinander angeordneten Linien über den Oberflächenbereich des Substrats geführt, wobei die Linien ihre benachbarten Linien jeweils zu etwa 85% überlappen. Dies hat den Vorteil, dass eine gleichmässige Bearbeitung des Oberflächenbereichs des Substrats mit dem Laserstrahl ermöglicht wird.

Alternativ dazu können sich die Linien auch zu mehr oder weniger als etwa 85% überlappen. Zudem kann im zweiten Schritt des Verfahrens der Laserstrahl auch anders als entlang nebeneinander angeordneten Linien über den Oberflächenbereich des Substrats geführt werden.

Bevorzugt wird zur Behandlung der Oberfläche des Oberflächenbereichs des Substrats im zweiten Schritt der Laserstrahl mit einer Scangeschwindigkeit im Bereich von 100mm/s bis 900mm/s, besonders bevorzugt im Bereich von 250mm/s bis 750mm/s, ganz besonders im Bereich von 400mm/s bis 600mm/s über die Oberfläche des Oberflächenbereichs des Substrats bewegt. Dies hat den Vorteil, dass der zweite Schritt des Verfahrens innerhalb von kurzer Zeit durchgeführt werden kann. Ausserdem hat dies den Vorteil, dass die Bewegung des Laserstrahls relativ zum Substrat ohne aufwändige Steuerung gut kontrolliert werden kann. Dadurch kann die Oberflächenzone des Oberflächenbereichs des Substrats im zweiten Schritt des Verfahrens in kontrollierter Weise gefestigt werden.

Alternativ dazu besteht aber auch die Möglichkeit, dass im zweiten Schritt der Laserstrahl mit einer Scangeschwindigkeit von weniger als 100mm/s oder mehr als 900mm/s über die Oberfläche des Oberflächenbereichs geführt wird.

Bevorzugt wird das erfindungsgemässe Verfahren zur Vorbereitung eines Oberflächenbereichs eines Substrats in einem Verfahren zur Beschichtung eingesetzt. Dabei handelt es sich bevorzugt um ein Verfahren zur Beschichtung eines Oberflächenbereichs eines Substrats, wobei der Oberflächenbereich des Substrats aus Hartstoff besteht, wobei der Hartstoff einen metallischen Binder enthält, wobei der Oberflächenbereich des Substrats mit den zwei Schritten des erfindungsgemässen Verfahrens für die Beschichtung vorbereitet wird und in einem dritten Schritt beschichtet wird. Dieses Verfahren hat den Vorteil, dass eine stark haftende Beschichtung des Substrats ermöglicht wird. Dabei besteht die Möglichkeit, dass im dritten Schritt nur der Oberflächenbereich des Substrats, welcher mit dem erfindungsgemässen Verfahren für die Beschichtung vorbereitet wird, beschichtet wird. Es besteht aber auch die Möglichkeit, dass im dritten Schritt zusätzlich auch noch ein oder mehrere andere Bereiche der Oberfläche des Substrats beschichtet werden. Solche andere Bereiche der Oberfläche des Substrats können räumlich an den Oberflächenbereich des Substrats, welcher mit dem erfindungsgemässen Verfahren vorbereitet wird, anschliessend angeordnet sein. Sie können aber auch räumlich getrennt vom Oberflächenbereich des Substrats, welcher mit dem erfindungsgemässen Verfahren vorbereitet wird, angeordnet sein. Unabhängig davon wird die Beschichtung aber in solchen anderen Bereichen weniger stark am Substrat haften als im mit dem erfindungsgemässen Verfahren vorbereiteten Oberflächenbereich des Substrats.Alternativ dazu besteht aber auch die Möglichkeit, dass das erfindungsgemässe Verfahren zur Vorbereitung eines Oberflächenbereichs eines Substrats für sich separat eingesetzt wird, ohne dass nachträglich der Oberflächenbereich des Substrats beschichtet wird.

Vorteilhafterweise wird im dritten Schritt des Verfahrens zur Beschichtung eines Oberflächenbereichs eines Substrats der Oberflächenbereich des Substrats mit einer Diamantbeschichtung oder mit einer Beschichtung mit wenigstens einem der Elemente Al oder Cr, wie beispielsweise einer TiAIN-Beschichtung oder einer TiAlCrN-Beschichtung, insbesondere einer Carbonitrit-Beschichtung mit wenigstens einem der Elemente Al oder Cr, wie beispielsweise einer TiAlCN-Beschichtung oder einer TiAlCrCN-Beschichtung beschichtet. Dies hat den Vorteil, dass eine stark haftende Beschichtung aus einem sehr harten Material erzeugt wird. Am stärksten wird dieser Vorteil jedoch mit einer Diamantbeschichtung erreicht.

Alternativ dazu kann im dritten Schritt des Verfahrens zur Beschichtung der Oberflächenbereich des Substrats aber auch mit einer anderen Beschichtung beschichtet werden.

Bevorzugt wird im dritten Schritt des Verfahrens zur Beschichtung eines Oberflächenbereichs eines Substrats die Beschichtung mittels chemischer Dampfbeschichtung auf dem Oberflächenbereich des Substrats aufgebracht. Dies hat den Vorteil, dass die Beschichtung kostengünstig aufgebracht werden kann.

In einer Variante dazu wird im dritten Schritt die Beschichtung mittels physikalischer Dampfbeschichtung auf dem Oberflächenbereich des Substrats aufgebracht. Dies hat den Vorteil, dass die Beschichtung kontrolliert mit den gewünschten Eigenschaften wie beispielsweise in einer gewünschten kristallinen Phase aufgetragen werden kann.

Alternativ dazu besteht aber auch die Möglichkeit, dass im dritten Schritt die Beschichtung mit einem anderen Verfahren auf dem Oberflächenbereich des Substrats aufgebracht wird.

Bevorzugt werden das Verfahren zur Beschichtung eines Oberflächenbereichs eines Substrats und damit auch das erfindungsgemässe Verfahren zur Vorbereitung eines Oberflächenbereichs eines Substrats in einem Verfahren zur Herstellung eines spanabtragenden Werkzeugs eingesetzt. Dabei handelt es sich bevorzugt um ein Verfahren zur Herstellung eines spanabtragenden Werkzeugs wie einem Bohrer oder Fräser, wobei das Werkzeug ein Substrat umfasst und wenigstens ein Oberflächenbereich des Substrats aus Hartstoff besteht und der Hartstoff einen metallischen Binder enthält, wobei der wenigstens eine Oberflächenbereich des Substrats mit dem Verfahren zur Beschichtung eines Oberflächenbereichs eines Substrats beschichtet wird, um einen spanabtragenden Bereich des Werkzeugs zu erzeugen. Dieses Verfahren hat den Vorteil, dass der spanabtragende Bereich des Werkzeugs durch eine stark haftende Beschichtung des Substrats gebildet wird. Entsprechend weist das Werkzeug eine lange Standzeit auf. Zudem können mit dem Werkzeug auch harte Materialien bearbeitet werden. Diese Vorteile werden unabhängig davon erreicht, ob im dritten Schritt nur der spanabtragende Bereich des Werkzeugs und damit nur der Oberflächenbereich des Substrats, welcher mit dem erfindungsgemässen Verfahren für die Beschichtung vorbereitet wird, beschichtet wird, oder ob im dritten Schritt zusätzlich auch noch ein oder mehrere andere Bereiche der Oberfläche des Substrats beschichtet werden. Dabei ist unerheblich, ob solche andere Bereiche des Substrats vor der Beschichtung gar nicht behandelt werden oder ob sie nur mit dem ersten Schritt oder nur mit dem zweiten Schritt des erfindungsgemässen Verfahrens behandelt werden. Ausserdem ist unerheblich, ob solche andere Bereiche der Oberfläche des Substrats räumlich anschliessend an den spanabtragenden Bereich des Werkzeugs und damit räumlich anschliessend an den Oberflächenbereich des Substrats, welcher mit dem erfindungsgemässen Verfahren vorbereitet wird, angeordnet sind oder ob sie räumlich getrennt vom spanabtragenden Bereich des Werkzeugs und damit räumlich getrennt vom Oberflächenbereich des Substrats, welcher mit dem erfindungsgemässen Verfahren vorbereitet wird, angeordnet sind. Unabhängig von diesen Möglichkeiten haftet die Beschichtung in solchen anderen Bereichen der Oberfläche des Substrats weniger stark am Substrat als im mit dem erfindungsgemässen Verfahren vorbereiteten Oberflächenbereich des Substrats. Dies ist jedoch kein Nachteil, weil die Beschichtung im spanabtragenden und damit im am stärksten beanspruchten Bereich des Werkzeugs besonders gut am Substrat haftet, da dieser Oberflächenbereich des Substrats vor der Beschichtung mit dem erfindungsgemässen Verfahren für die Beschichtung vorbereitet wurde.

Bevorzugt handelt es sich beim spanabtragenden Bereich des Werkzeugs um eine Spanfläche und eine Freifläche, zwischen welchen eine Schneidkante angeordnet ist. In diesem Fall wird der Laserstrahl im zweiten Schritt des Verfahrens bevorzugt entlang von nebeneinander angeordneten Linien über den Oberflächenbereich des Substrats geführt, welcher den spanabtragenden Bereich des fertigen Werkezugs bilden wird, wobei der Laserstrahl jeweils entlang der Linien ausgehend von der Spanfläche des zukünftigen Werkzeugs über die Schneidkante des zukünftigen Werkzeugs hinaus geführt wird und ausgehend von der Freifläche des zukünftigen Werkzeugs über die Schneidkante des zukünftigen Werkzeugs hinaus geführt wird. Dies hat den Vorteil, dass im zweiten Schritt die Schneidkante des zukünftigen Werkzeugs optimal für die Beschichtung vorbereitet wird. In einer Variante dazu kann der Laserstrahl im zweiten Schritt aber auch anders relativ zur Schneidkante des zukünftigen über den Oberflächenbereich des Substrats geführt werden.

Alternativ dazu besteht aber auch die Möglichkeit, dass es sich beim spanabtragenden Bereich des Werkzeugs um einen anderen Bereich handelt.

Alternativ dazu besteht aber auch die Möglichkeit, dass das Verfahren zur Beschichtung eines Oberflächenbereichs eines Substrats für sich separat eingesetzt wird, ohne dass damit ein spanabtragendes Werkzeug hergestellt wird. Genauso kann auch das erfindungsgemässe Verfahren zur Vorbereitung eines Oberflächenbereichs eines Substrats für sich separat eingesetzt werden, ohne dass damit ein spanabtragendes Werkzeug hergestellt wird und ohne dass nachträglich der Oberflächenbereich des Substrats beschichtet wird.

Erfindungsgemäss ist ein spanabtragendes Werkzeug wie ein Bohrer oder Fräser mit dem Verfahren zur Herstellung eines spanabtragenden Werkzeugs hergestellt. Dies hat den Vorteil, dass das spanabtragende Werkzeug eine längere Standzeit aufweist als herkömmliche spanabtragende Werkzeuge.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: ein Flussdiagramm eines erfindungsgemässen Verfahrens zur Vorbereitung eines Oberflächenbereichs eines Substrats für eine Beschichtung des Oberflächenbereichs des Substrats,
- Fig. 2: eine schematische Darstellung eines Querschnitts durch das Substrat vor der Durchführung des Verfahrens,
- Fig. 3a, b: eine schematische Darstellung eines Querschnitts durch das Substrat nach der Behandlung mit Lauge bzw. nach der Behandlung mit Säure,
- Fig. 4: eine schematische Darstellung eines Querschnitts durch das Substrat nach der Behandlung der Oberfläche des Substrats mit einem Laserstrahl,
- Fig. 5: ein Flussdiagramm eines Verfahrens zur Beschichtung eines Substrats, bei welchem der Oberflächenbereich des Substrats mit dem erfindungsgemässen Verfahren für die Beschichtung vorbereitet wird,
- Fig. 6: eine schematische Darstellung eines Querschnitts eines entsprechend beschichteten Substrats, und
- Fig. 7: eine schematische Darstellung eines spanabtragenden Bereichs eines Werkzeugs, welches mit dem erfindungsgemässen Verfahren für eine Beschichtung vorbereitet wurde und danach beschichtet wurde.

Grundsätzlich sind in den Figuren gleiche Teile mit gleichen Bezugszeichen versehen.

### Wege zur Ausführung der Erfindung

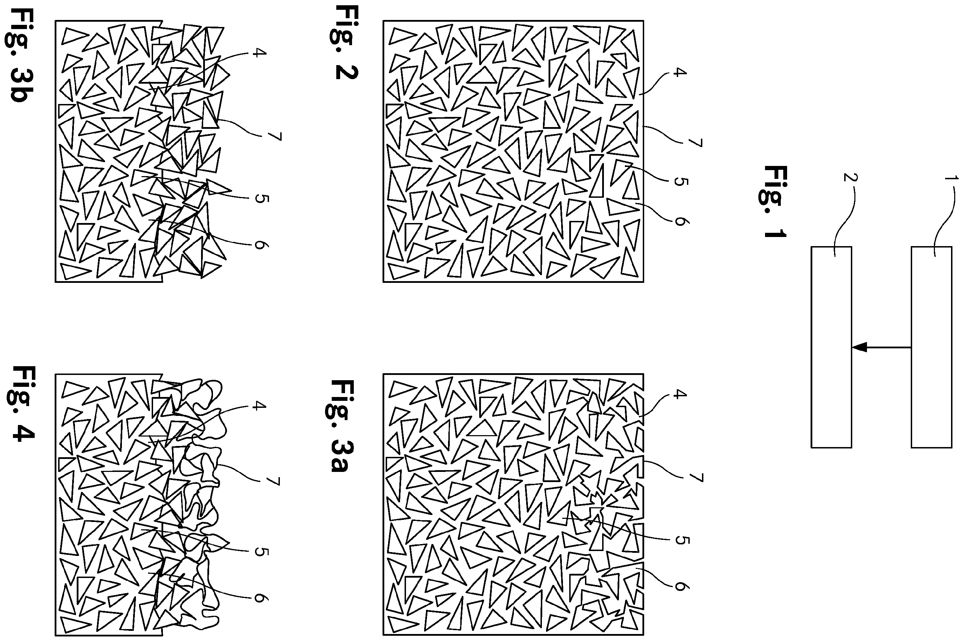

Figur 1 zeigt ein Flussdiagramm eines erfindungsgemässen Verfahrens zur Vorbereitung eines Oberflächenbereichs eines Substrats für eine Beschichtung des Oberflächenbereichs des Substrats.

Das mit dem Verfahren bearbeitete Substrat besteht aus Hartstoff mit einer Hartstoffphase und einem metallischen Binder. Die Hartstoffphase ist Wolframkarbid, während der metallische Binder Kobalt ist. Damit ist der Hartstoff mit metallischem Binder ein Hartmetall mit metallischem Binder.

Im vorliegenden Fall hat der Hartstoff mit dem metallischen Binder einen Anteil von 99.5 Gewichtsprozent oder mehr am gesamten Substrat. Wie in Figur 2 in einer schematischen Querschnittsdarstellung gezeigt, weist das Substrat 4 vor der Durchführung des Verfahrens gleichmässig im Substrat 4 verteilte Körner 5 aus Wolframkarbid mit einer Korngrösse im Bereich von 0.3µm bis 0.9µm auf, welche durch den metallischen Binder 6 Kobalt miteinander verbunden sind. Es besteht aber auch die Möglichkeit, dass die Körner 5 aus Wolframkarbid eine Korngrösse von 0.3µm bis 1.9µm oder bis 2.9µm aufweisen. Die Körner 5 aus Wolframkarbid können aber auch grösser oder kleiner sein. Über das Volumen von mehreren Körnern 5 gemittelt, ist der Gewichtsanteil des metallischen Binders 6 am Hartmetall bzw. Hartstoff vor der Durchführung des Verfahrens überall im Substrat 4 etwa 7 Gewichtsprozent bis 9 Gewichtsprozent des Hartmetalls bzw. Hartstoffs. Das Substrat 4 kann im Hartmetall nebst Wolframkarbid auch Spuren von anderen Hartmetallen wie beispielsweise Titankarbid, Tantalkarbid, Chromcarbid, Molybdänkarbid oder Vanadiumkarbid enthalten. Ausserdem kann der Hartstoff mit metallischem Binder anstelle von Hartmetall mit metallischem Binder auch ein Cermet mit metallischem Binder sein. In diesem Fall kann das Cermet als Hartstoffphase beispielsweise ein Karbonitrid wie TiCₓN_{y} oder WCₓN_{y} sein. Dabei kann der metallische Binder beispielsweise Nickel, Kobalt oder Eisen sein.

In einem ersten Schritt 1 des Verfahrens wird eine Oberfläche 6 des Oberflächenbereichs des Substrats 4 chemisch geätzt, um in einer Oberflächenzone des Oberflächenbereichs des Substrats 4 einen Gewichtsanteil des metallischen Binders 6 am Hartstoff zu reduzieren. Dabei ist die Oberflächenzone des Oberflächenbereichs des Substrats 4 die Zone, innerhalb von welcher der Gewichtsanteil des metallischen Binders 6 nach der Durchführung des ersten Schritts 1 des Verfahrens auf mindestens 1/e, bzw. 36.79% des Gewichtsanteils des metallischen Binders 6 vor der Durchführung des ersten Schritts 1 des Verfahrens reduziert ist.

Um die Oberfläche 7 des Oberflächenbereichs des Substrats 4 im ersten Schritt 1 des Verfahrens derart chemisch zu ätzen, wird die Oberfläche 7 zuerst mit einer Lauge aus einem Gewichtsanteil Kaliumhydroxid (KOH) und einem Gewichtsanteil Kaliumhexacyanidoferrat(III) (K₃[Fe(CN)₆]) auf zehn Gewichtsanteile Wasser (H₂O) und danach mit einer Säure aus einem Volumenanteil Wasserstoffperoxid (H₂O₂) und einem Volumenanteil Dihydrogensulfat (H₂SO₄) auf beispielsweise etwa 7 Volumenanteile Wasser (H₂O) behandelt. Um unerwünschte Reaktionen der Säure mit der Lauge zu verhindern, wird der Oberflächenbereich des Substrats 4 zwischen der Behandlung mit der Lauge und der Behandlung mit der Säure mit Wasser (H₂O) abgespült und getrocknet.

Wie in der schematischen Querschnittsdarstellung des Substrats 4 nach der Behandlung mit Lauge in Figur 3a gezeigt, werden durch die Lauge in einem Oberflächenbereich des Substrats 4 Körner 5 aus Wolframkarbid aus dem metallischen Binder 6 herausgelöst. Dadurch wird die Angriffsfläche für die nachfolgend eingesetzte Säure erhöht. Mit der Säure wird der Gewichtsanteil des metallischen Binders 6 am Hartmetall bzw. Hartstoff in der Oberflächenzone des Oberflächenbereichs des Substrats 4, wie in der Querschnittsdarstellung in Figur 3b schematisch gezeigt, reduziert. Dadurch befinden sich im Oberflächenbereich des Substrats 4 teilweise lose Körner 5 aus Wolframkarbid.

Nach der Durchführung des ersten Schritts 1 des Verfahrens ist im Drittel der Oberflächenzone des Oberflächenbereichs des Substrats 4, welcher der Oberfläche des Oberflächenbereichs am nächsten liegt, der Gewichtsanteil des metallischen Binders 6 am Hartmetall bzw. Hartstoff auf weniger als 0.1 Gewichtsprozent des Hartmetalls bzw. Hartstoffs reduziert. Dabei reicht der Drittel der Oberflächenzone des Oberflächenbereichs des Substrats 4, welcher der Oberfläche 7 des Oberflächenbereichs am nächsten liegt, von der Oberfläche 7 des Oberflächenbereichs des Substrats 4 bis einen Drittel der Tiefe in das Substrat 4 hinein, bis in welche die Oberflächenzone ausgehend von der Oberfläche 7 des Substrats 4 in das Substrat 4 hinein reicht.

In einem zweiten Schritt 2 des Verfahrens wird ein Laserstrahl über die Oberfläche 7 des Oberflächenbereichs des Substrats 4 geführt, um die Oberflächenzone des Oberflächenbereichs des Substrats 4 zu festigen. Dabei handelt es sich um einen gepulsten Laserstrahl, welcher mit einem Dioden-gepumpten Festkörperlaser erzeugt wird, dessen Laserkristall Neodym dotiertes Yttrium-Vanadat (Nd:YVO₄) ist. Die Wellenlänge des Laserstrahls beträgt 1064nm, während die Laserpulse eine Pulsdauer von 14ps aufweisen. Dabei sind die Laserpulse in zeitlich regelmässigen Häufungen von jeweils 8 Laserpulsen angeordnet. Diese 8 Laserpulse innerhalb einer Häufung folgen sich in einem Zeitabstand von 20ns. Die Häufungen der Laserpulse hingegen beginnen jeweils zeitlich um 1µs versetzt. Damit weisen die Häufungen eine Wiederholrate von 1'000kHz auf, was im vorliegenden Fall als Pulsfrequenz des Laserstrahls bezeichnet wird. Es besteht aber auch die Möglichkeit, dass der Laserstrahl eine andere Pulsfrequenz wie beispielsweise 500kHz aufweist. Zudem können die zeitlichen Abstände der einzelnen Laserpulse innerhalb einer Häufung anders gewählt sein. Auch können die Häufungen eine kleinere oder grössere Anzahl einzelner Laserpulse als 8 Laserpulse aufweisen. Als Variante dazu kann der Laserstrahl aber anstelle von regelmässig wiederholten Häufungen von Laserpulsen auch zeitlich regelmässig beabstandete Laserpulse aufweisen. Dabei kann die Wiederholrate der Laserpulse beispielsweise einer Pulsfrequenz von 1'000kHz oder 500kHz entsprechen.

Im zweiten Schritt 2 des Verfahrens weist der Laserstrahl, über mehrere Häufungen von Laserpulsen gemittelt, eine mittlere Leistung von 7 Watt auf. Dabei wird der Laserstrahl an der Stelle, an welcher der Laserstrahl auf die Oberfläche 7 des Oberflächenbereichs des Substrats 4 auftrifft, senkrecht zur Oberfläche 7 des Oberflächenbereichs des Substrats 4 ausgerichtet. Dabei wird der Laserstrahl auf den Oberflächenbereich des Substrats 4 fokussiert, sodass sich der Fokuspunkt des Laserstrahls auf der Oberfläche 7 des Substrats 4 befindet und einen Durchmesser von etwa 35 µm aufweist. Für die Durchführung des zweiten Schritts 2 des Verfahrens wird der Laserstrahl entlang von nebeneinander angeordneten Linien über den Oberflächenbereich des Substrats 4 geführt, wobei Zentren der Linien jeweils einen Abstand von 5 µm aufweisen. Dadurch überlappen die Linien ihre benachbarten Linien jeweils zu etwa 85 %. Dabei wird der Laserstrahl mit einer Geschwindigkeit von 500mm/s über die Oberfläche 7 des Oberflächenbereichs des Substrats 4 bewegt.

Wie bereits erwähnt, wird im zweiten Schritt 2 des Verfahrens der Laserstrahl über die Oberfläche 7 des Oberflächenbereichs des Substrats 4 geführt, um die Oberflächenzone des Oberflächenbereichs des Substrats 4 zu festigen. Figur 4 zeigt eine schematische Querschnittsdarstellung des Substrats 4 nach der Durchführung des zweiten Schritts 2 des Verfahrens. Wie in der Figur gezeigt ist, bleibt eine teilweise verschweisste Gerüststruktur in der Oberflächenzone bestehen. Das bedeutet, dass während der Laserbehandlung die Oberflächenzone des Oberflächenbereichs des Substrats 4 nicht gänzlich aufgeschmolzen wird und dass es somit auch nicht zu einer Verglasung der Oberflächenzone kommt. Vielmehr wird durch die Laserbehandlung einzig der Zusammenhalt der körnigen Gerüststruktur erhöht. Dieser Vorgang kann auch als Gerüstverstärkung oder als Verkrustung der Oberflächenzone bezeichnet werden.

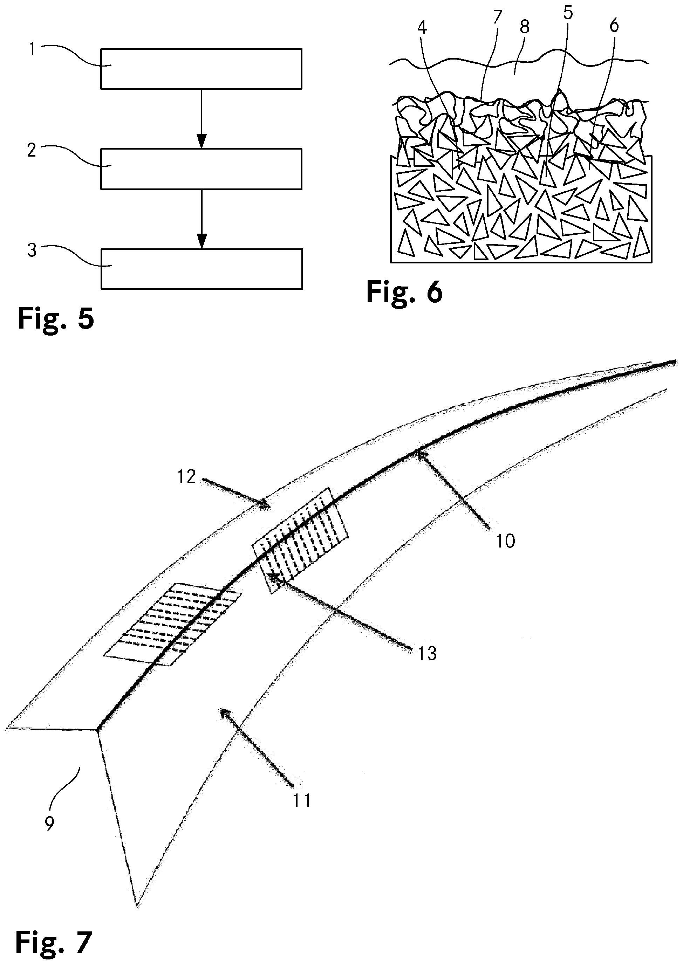

Das erfindungsgemässe Verfahren kann in einem Verfahren zur Beschichtung eines Oberflächenbereichs eines Substrats eingesetzt werden. Wie im Flussdiagramm in Figur 5 gezeigt, wird dabei der Oberflächenbereich des Substrats 4 zuerst mit dem ersten Schritt 1 und dem zweiten Schritt 2 des erfindungsgemässen Verfahrens wie vorgängig beschrieben vorbereitet. Danach wird in einem dritten Schritt 3 der Oberflächenbereich des Substrats 4 mittels chemischer Dampfbeschichtung oder physikalischer Dampfbeschichtung mit einer Diamantschicht 8 beschichtet. Figur 6 zeigt eine schematische Darstellung eines Querschnitts eines entsprechend mit einer Diamantschicht 8 beschichteten Substrats 4.

Bei diesem Verfahren zu Beschichtung eines Oberflächenbereichs des Substrats ist unerheblich, ob im dritten Schritt nur der Oberflächenbereich des Substrats, welcher mit dem erfindungsgemässen Verfahren für die Beschichtung vorbereitet wird, beschichtet wird, oder ob im dritten Schritt zusätzlich auch noch ein oder mehrere andere Bereiche der Oberfläche des Substrats beschichtet werden. Dabei können solche andere Bereiche der Oberfläche des Substrats räumlich an den Oberflächenbereich des Substrats, welcher mit dem erfindungsgemässen Verfahren vorbereitet wird, anschliessend angeordnet sein. Sie können aber auch räumlich getrennt vom Oberflächenbereich des Substrats, welcher mit dem erfindungsgemässen Verfahren vorbereitet wird, angeordnet sein.

Das Verfahren zur Beschichtung eines Oberflächenbereichs eines Substrats kann in einem Verfahren zur Herstellung eines spanabtragenden Werkzeugs wie beispielsweise einem Bohrer oder Fräser eingesetzt werden. Dabei kann ein spanabtragender Bereich des Werkzeugs 9 mit dem Verfahren beschichtet werden. Hierzu kann beispielsweise im ersten Schritt ein grosser Bereich der Oberfläche des Substrats chemisch geätzt werden, um in der Oberflächenzone dieses Bereichs des Substrats den Gewichtsanteil des metallischen Binders am Hartstoff zu reduzieren. Danach kann beispielsweise im zweiten Schritt der Laserstrahl nur über einen Teilbereich des im ersten Schritt chemisch geätzten, grossen Bereichs der Oberfläche des Substrats geführt werden, um die Oberflächenzone dieses Teilbereichs der Oberfläche des Substrats zu festigen. In diesem Fall ist nur dieser Teilbereich als der für die Beschichtung des Substrats vorzubereitende Oberflächenbereich des Substrats zu verstehen. Danach kann im dritten Schritt ein Bereich der Oberfläche des Substrats beschichtet werden, welcher den Teilbereich der Oberfläche des Substrats mit einschliesst, aber gleich gross oder grösser als der Teilbereich sein kann. Ob der Bereich dabei kleiner, gleich gross oder grösser als der im ersten Schritt chemisch geätzte, grosse Bereich der Oberfläche des Substrats ist, ist dabei unerheblich.

Figur 7 zeigt eine schematische Darstellung des spanabtragenden Bereichs eines mit dem Verfahren hergestellten Werkzeugs 9. Dabei umfasst der spanabtragende Bereich des Werkzeugs 9 eine Schneidkante 10 sowie eine auf der einen Seite der Schneidkante 10 angeordnete Spanfläche 11 und eine auf der anderen Seite der Schneidkante 10 angeordnete Freifläche 12. Um dieses Werkzeug 9 herzustellen, wird zuerst aus einem Substratmaterial ein Substrat 4 mit der Werkzeugform hergestellt. Danach werden die Bereiche des Substrats 4, welche beim fertiggestellten Werkzeug 9 die spanabtragenden Bereiche bilden, wie oben beschrieben mit dem erfindungsgemässen Verfahren für die Beschichtung vorbereitet. Im ersten Schritt 1 ist unerheblich, wie gross der chemisch geätzte Bereich der Oberfläche des Substrats 4 ist. Im zweiten Schritt 2 des Verfahrens wird der Laserstrahl in einem Lasermuster 13 über den Oberflächenbereich des Substrats 4 geführt, welcher beim fertigen Werkzeug 9 die Spanfläche 11 und die Freifläche 12 mit der dazwischen angeordneten Schneidkante 10 bildet. Hierzu wird der Laserstrahl senkrecht zur gerade bearbeiteten Oberfläche ausgerichtet entlang von nebeneinander angeordneten Linien über den Oberflächenbereich des Substrats 4 geführt. Wie in der Figur 7 mit den schematischen Darstellungen des Lasermusters 13 illustriert, wird der Laserstrahl dabei entlang der Linien ausgehend von der Spanfläche 11 über die Schneidkante 10 hinaus geführt bzw. ausgehend von der Freifläche 12 über die Schneidkante 10 hinaus geführt. Nach dieser Behandlung mit dem Laserstrahl wird im dritten Schritt 3 der Oberflächenbereich des Substrats 4 beschichtet, um den spanabtragenden Bereich des Werkzeugs 9 zu bilden. Ob dabei auch noch weitere Bereiche der Oberfläche des Substrats 4 als der Oberflächenbereich beschichtet werden, ist unerheblich.

Die Erfindung ist nicht auf die vorgehend beschriebenen Verfahren und das vorgehend beschriebene Werkzeug 9 beschränkt. Vielmehr sind diverse Abwandlungen der Erfindung möglich. Beispielsweise ist es nicht erforderlich, dass das gesamte Substrat aus Hartstoff mit metallischem Binder besteht. Es reicht aus, wenn der Oberflächenbereich des Substrats aus Hartstoff mit metallischem Binder besteht. Weiter ist nicht erforderlich, dass der Hartstoff eine Körnerstruktur mit Körnern aus Hartstoffphase aufweist, welche durch einen metallischen Binder miteinander verbunden sind. Der Hartstoff mit dem metallischen Binder kann auch eine andere Struktur aufweisen.

Weiter besteht die Möglichkeit, dass der Oberflächenbereich des Substrats aus einem Hartmetall mit einer anderen Hartstoffphase als Wolframkarbid oder anstelle von Hartmetall wie bereits erwähnt aus Cermet oder einem sonstigen Hartstoff besteht. Im Falle von Hartmetall als Hartstoff kann die Hartstoffphase anstelle von Wolframkarbid beispielsweise auch Titankarbid oder Titannitrid sein. Auch muss der metallische Binder nicht Kobalt sein. Er kann beispielsweise auch eine Kobaltlegierung, Nickel, eine Nickellegierung, Molybdän oder eine Molybdänlegierung sein.

Es besteht auch die Möglichkeit, dass im ersten Schritt des Verfahrens eine andere Lauge, eine andere Säure oder sowohl eine andere Lauge als auch eine andere Säure verwendet wird. Zudem besteht die Möglichkeit, dass auf den Zwischenschritt des Abspülens und Trocknens verzichtet wird. Abgesehen davon besteht jedoch auch die Möglichkeit, dass die Oberfläche des Oberflächenbereichs des Substrats im ersten Schritt des Verfahrens weder mit einer Säure noch mit einer Lauge, sondern mit einem anderen Mittel chemisch geätzt wird.

Für die Durchführung des zweiten Schritts des Verfahrens kann, wie bereits erwähnt, auch ein Laserstrahl verwendet werden, welcher nicht durch einen Dioden-gepumpten Festkörperlaser mit Neodym dotiertem Yttrium-Vanadat (Nd:YVO₄) als Laserkristall erzeugt wird. Zudem ist nicht erforderlich, dass die Wellenlänge des Laserstrahls 1'064 nm beträgt. Weiter kann die Pulsdauer der Laserpulse auch länger oder kürzer als 14ps sein. Zudem besteht die Möglichkeit, dass die Pulsfrequenz anders als 500kHz oder 1'000kHz ist oder dass der Laserstrahl ein kontinuierlicher Laserstrahl ist. Ausserdem kann der Laserstrahl auch mit mehr oder weniger als 500mm/s über den zu bearbeitenden Bereich des Substrats bewegt werden.

Weiter kann im dritten Schritt des Verfahrens anstelle der Diamantbeschichtung zur Beschichtung eines Oberflächenbereichs des Substrats auch eine andere Beschichtung wie beispielsweise eine Beschichtung mit wenigstens einem der Elemente Al oder Cr, wie beispielsweise einer TiAIN-Beschichtung oder einer TiAlCrN-Beschichtung, insbesondere einer Carbonitrit-Beschichtung mit wenigstens einem der Elemente Al oder Cr, wie beispielsweise einer TiAlCN-Beschichtung oder einer TiAlCrCN-Beschichtung aufgebracht werden.

Zusammenfassend ist festzustellen, dass ein Verfahren zur Vorbereitung eines Oberflächenbereichs eines Substrats aus Hartstoff geschaffen wird, welches die Beschichtung mit einer stark haftenden Schicht ermöglicht. Dieses Verfahren kann in einem Verfahren zur Beschichtung eines Oberflächenbereichs eines Substrats sowie zur Herstellung eines spanabtragenden Werkzeugs eingesetzt werden.

## Patentansprüche

1. Verfahren zur Vorbereitung eines Oberflächenbereichs eines Substrats (4) für eine Beschichtung des Oberflächenbereichs des Substrats (4), wobei der Oberflächenbereich des Substrats (4) aus Hartstoff besteht, wobei der Hartstoff einen metallischen Binder (6) enthält, wobei
in einem ersten Schritt (1) eine Oberfläche des Oberflächenbereichs des Substrats (4) chemisch geätzt wird, um in einer Oberflächenzone des Oberflächenbereichs des Substrats (4) einen Gewichtsanteil des metallischen Binders (6) am Hartstoff zu reduzieren, und
in einem zweiten Schritt (2) ein gepulster Laserstrahl über die Oberfläche (7) des Oberflächenbereichs des Substrats (4) geführt wird, um die Oberflächenzone des Oberflächenbereichs des Substrats (4) zu festigen,
**dadurch gekennzeichnet, dass** der gepulste Laserstrahl eine Pulsdauer von höchstens 20ps aufweist.

2. Verfahren nach Anspruch 1, **dadurch gekennzeichnet, dass** die Oberflächenzone von der Oberfläche (7) des Oberflächenbereichs des Substrats (4) bis etwa 30µm, bevorzugt bis etwa 20µm, besonders bevorzugt bis etwa 10µm tief in das Substrat (7) reicht.

3. Verfahren nach einem der Ansprüche 1 oder 2, **dadurch gekennzeichnet, dass** vor der Durchführung des ersten Schritts (1) der Gewichtsanteil des metallischen Binders (6) am Hartstoff in der Oberflächenzone des Oberflächenbereichs des Substrats (4) in einem Bereich von 5 bis 20 Gewichtsprozent des Hartstoffs, bevorzugt in einem Bereich von 5 bis 15 Gewichtsprozent des Hartstoffs, besonders bevorzugt in einem Bereich von 6 bis 12 Gewichtsprozent des Hartstoffs liegt.

4. Verfahren nach einem der Ansprüche 1 bis 3, **dadurch gekennzeichnet, dass** durch die Durchführung des ersten Schritts (1) der Gewichtsanteil des metallischen Binders (6) am Hartstoff im Drittel der Oberflächenzone des Oberflächenbereichs des Substrats (4), welcher der Oberfläche (7) des Oberflächenbereichs am nächsten liegt, auf weniger als 1 Gewichtsprozent des Hartstoffs, bevorzugt auf weniger als 0.5 Gewichtsprozent des Hartstoffs, besonders bevorzugt auf weniger als 0.1 Gewichtsprozent des Hartstoffs reduziert wird.

5. Verfahren nach einem der Ansprüche 1 bis 4, **dadurch gekennzeichnet, dass** der Hartstoff ein Hartmetall oder ein Cermet ist.

6. Verfahren nach einem der Ansprüche 1 bis 5, **dadurch gekennzeichnet, dass** der metallische Binder (6) Kobalt, eine Kobaltlegierung, Nickel, eine Nickellegierung, Molybdän, eine Molybdänlegierung, Eisen oder eine Eisenlegierung ist.

7. Verfahren nach einem der Ansprüche 1 bis 6, **dadurch gekennzeichnet, dass** im ersten Schritt (1) des Verfahrens die Oberfläche (7) des Oberflächenbereichs des Substrats (4) mit einer Lauge behandelt wird.

8. Verfahren nach einem der Ansprüche 1 bis 7, **dadurch gekennzeichnet, dass** im ersten Schritt (1) des Verfahrens die Oberfläche (7) des Oberflächenbereichs des Substrats (4) mit einer Säure behandelt wird.

9. Verfahren nach Anspruch 7 und 8, **dadurch gekennzeichnet, dass** im ersten Schritt (1) des Verfahrens die Oberfläche (7) des Oberflächenbereichs des Substrats (4) zuerst mit Lauge und danach mit Säure behandelt wird.

10. Verfahren nach einem der Ansprüche 1 bis 9, **dadurch gekennzeichnet, dass** der Laserstrahl ein gepulster Laserstrahl mit einer Pulsdauer von höchstens 15ps, besonders bevorzugt höchstens 14ps ist.

11. Verfahren nach einem der Ansprüche 1 bis 10, **dadurch gekennzeichnet, dass** der Laserstrahl ein gepulster Laserstrahl mit einer Pulsfrequenz im Bereich von 100kHz bis 2'000kHz, bevorzugt im Bereich von 400kHz bis 1'600kHz, besonders bevorzugt im Bereich von 800kHz bis 1'200kHz ist.

12. Verfahren zur Beschichtung eines Oberflächenbereichs eines Substrats (4), wobei der Oberflächenbereich des Substrats (4) aus Hartstoff besteht, wobei der Hartstoff einen metallischen Binder (6) enthält, **dadurch gekennzeichnet, dass** der Oberflächenbereich des Substrats (4) mit den zwei Schritten (1, 2) des Verfahrens nach einem der Ansprüche 1 bis 11 für die Beschichtung vorbereitet wird und in einem dritten Schritt (3) beschichtet wird.

13. Verfahren nach Anspruch 12, **dadurch gekennzeichnet, dass** im dritten Schritt (3) der Oberflächenbereich des Substrats (4) mit einer Diamantbeschichtung (8) oder mit einer Beschichtung mit wenigstens einem der Elemente Al oder Cr, wie beispielsweise einer TiAIN-Beschichtung oder einer TiAlCrN-Beschichtung, insbesondere mit einer Carbonitrit-Beschichtung mit wenigstens einem der Elemente Al oder Cr wie beispielsweise einer TiAlCN-Beschichtung oder einer TiAlCrCN-Beschichtung beschichtet wird.

14. Verfahren zur Herstellung eines spanabtragenden Werkzeugs (9) wie einem Bohrer oder Fräser, wobei das Werkzeug (9) ein Substrat (4) umfasst und wenigstens ein Oberflächenbereich des Substrats (4) aus Hartstoff besteht und der Hartstoff einen metallischen Binder (6) enthält, **dadurch gekennzeichnet, dass** der wenigstens eine Oberflächenbereich des Substrats (4) mit dem Verfahren nach einem der Ansprüche 12 oder 13 beschichtet wird, um einen spanabtragenden Bereich des Werkzeugs (9) zu erzeugen.

## Claims

1. Process for preparing a surface region of a substrate (4) for coating of the surface region of the substrate (4), where the surface region of the substrate (4) consists of hard material, where the hard material contains a metallic binder (6), where,
in a first step (1), a surface of the surface region of the substrate (4) is chemically etched in order to reduce a proportion by weight of the metallic binder (6) in the hard material in a surface zone of the surface region of the substrate (4), and,
in a second step (2), a pulsed laser beam is passed over the surface (7) of the surface region of the substrate (4) in order to strengthen the surface zone of the surface region of the substrate (4),
**characterized in that** the pulsed laser beam has a pulse duration of not more than 20 ps.

2. Process according to Claim 1, **characterized in that** the surface zone of the surface (7) of the surface region of the substrate (4) extends to a depth of about 30 µm, preferably about 20 µm, particularly preferably about 10 µm, into the substrate (7).

3. Process according to either of Claims 1 or 2, **characterized in that,** before carrying out the first step (1), the proportion by weight of the metallic binder (6) in the hard material in the surface zone of the surface region of the substrate (4) is in a range from 5 to 20 per cent by weight of the hard material, preferably in a range from 5 to 15 per cent by weight of the hard material, particularly preferably in a range from 6 to 12 per cent by weight of the hard material.

4. Process according to any of Claims 1 to 3, **characterized in that** the proportion by weight of the metallic binder (6) in the hard material in the third of the surface zone of the surface region of the substrate (4) which is closest to the surface (7) of the surface region is reduced to less than 1 per cent by weight of the hard material, preferably to less than 0.5 per cent by weight of the hard material, particularly preferably to less than 0.1 per cent by weight of the hard material, by carrying out the first step (1).

5. Process according to any of Claims 1 to 4, **characterized in that** the hard material is a cemented hard metal or a cermet.

6. Process according to any of Claims 1 to 5, **characterized in that** the metallic binder (6) is cobalt, a cobalt alloy, nickel, a nickel alloy, molybdenum, a molybdenum alloy, iron or an iron alloy.

7. Process according to any of Claims 1 to 6, **characterized in that** the surface (7) of the surface region of the substrate (4) is treated with a caustic alkali in the first step (1) of the process.

8. Process according to any of Claim 1 to 7, **characterized in that** the surface (7) of the surface region of the substrate (4) is treated with an acid in the first step (1) of the process.

9. Process according to Claim 7 or 8, **characterized in that** the surface (7) of the surface region of the substrate (4) is treated firstly with caustic alkali and then with acid in the first step (1) of the process.

10. Process according to any of Claims 1 to 9, **characterized in that** the laser beam is a pulsed laser beam having a pulse duration of not more than 15 ps, particularly preferably not more than 14 ps.

11. Process according to any of Claims 1 to 10, **characterized in that** the laser beam is a pulsed laser beam having a pulse frequency in the range from 100 kHz to 2000 kHz, preferably in the range from 400 kHz to 1600 kHz, particularly preferably in the range from 800 kHz to 1200 kHz.

12. Process for coating a surface region of a substrate (4), where the surface region of the substrate (4) consists of hard material, where the hard material contains a metallic binder (6), **characterized in that** the surface region of the substrate (4) is prepared for coating by means of two steps (1, 2) of the process according to any of Claims 1 to 11 and is coated in a third step (3).

13. Process according to Claim 12, **characterized in that** the surface region of the substrate (4) is coated with a diamond coating (8) or with a coating comprising at least one of the elements Al or Cr, for example a TiAlN coating or a TiAlCrN coating, in particular with a carbonitride coating comprising at least one of the elements Al or Cr, for example a TiAlCN coating or a TiAlCrCN coating, in the third step (3).

14. Process for producing a cutting tool (9) such as a drill or milling cutter, where the tool (9) comprises a substrate (4) and at least one surface region of the substrate (4) consists of hard material and the hard material contains a metallic binder (6), **characterized in that** the at least one surface region of the substrate (4) is coated by the process according to either of Claims 12 or 13 in order to produce a cutting region of the tool (9).

## Revendications

1. Procédé de préparation d'une zone de surface d'un substrat (4) pour un revêtement de la zone de surface du substrat (4), dans lequel la zone de surface du substrat (4) est constituée d'un matériau dur, dans lequel le matériau dur contient un liant métallique (6), dans lequel,
lors d'une première étape (1), une surface de la zone de surface du substrat (4) est attaquée chimiquement afin de réduire une proportion pondérale du liant métallique (6) par rapport au matériau dur dans une région de surface de la zone de surface du substrat (4), et
lors d'une deuxième étape (2), un faisceau laser pulsé est dirigé sur la surface (7) de la zone de surface du substrat (4) afin de renforcer la région de surface de la zone de surface du substrat (4),
**caractérisé en ce que** le faisceau laser pulsé présente une durée d'impulsion de 20ps au maximum.

2. Procédé selon la revendication 1, **caractérisé en ce que** la région de surface s'étend de la surface (7) de la zone de surface du substrat (4) jusqu'à une profondeur d'environ 30µm, de préférence jusqu'à une profondeur d'environ 20µm, et de manière particulièrement préférée jusqu'à une profondeur d'environ 10µm dans le substrat (7) .

3. Procédé selon l'une des revendications 1 ou 2, **caractérisé en ce qu'**avant que la première étape (1) soit réalisée, la proportion pondérale du liant métallique (6) par rapport au matériau dur dans la région de surface de la zone de surface du substrat (4) se situe dans une plage de 5 à 20 pour cent en poids du matériau dur, de préférence dans une plage de 5 à 15 pour cent en poids du matériau dur, et de manière particulièrement préférée dans une plage de 6 à 12 pour cent en poids du matériau dur.

4. Procédé selon l'une des revendications 1 à 3, **caractérisé en ce que**, du fait de la réalisation de la première étape (1), la proportion pondérale du liant métallique (6) par rapport au matériau dur dans le tiers de la région de surface de la zone de surface du substrat (4) qui est le plus proche de la surface (7) de la zone de surface est réduite à moins de 1 pour cent en poids du matériau dur, de préférence à moins de 0,5 pour cent en poids du matériau dur, et de manière particulièrement préférée à moins de 0,1 pour cent en poids du matériau dur.

5. Procédé selon l'une des revendications 1 à 4, **caractérisé en ce que** le matériau dur est un métal dur ou un cermet.

6. Procédé selon l'une des revendications 1 à 5, **caractérisé en ce que** le liant métallique (6) est le cobalt, un alliage de cobalt, le nickel, un alliage de nickel, le molybdène, un alliage de molybdène, le fer ou un alliage de fer.

7. Procédé selon l'une des revendications 1 à 6, **caractérisé en ce que**, lors de la première étape (1) du procédé, la surface (7) de la zone de surface du substrat (4) est traitée par une base.

8. Procédé selon l'une des revendications 1 à 7, **caractérisé en ce que**, lors de la première étape (1) du procédé, la surface (7) de la zone de surface du substrat (4) est traitée par un acide.

9. Procédé selon les revendications 7 et 8, **caractérisé en ce que**, lors de la première étape (1) du procédé, la surface (7) de la zone de surface du substrat (4) est traitée en premier lieu par une base, puis par un acide.

10. Procédé selon l'une des revendications 1 à 9, **caractérisé en ce que** le faisceau laser est un faisceau laser pulsé présentant une durée d'impulsion de 15ps au maximum, de préférence de 14ps au maximum.

11. Procédé selon l'une des revendications 1 à 10, **caractérisé en ce que** le faisceau laser est un faisceau laser pulsé présentant une fréquence d'impulsion se situant dans la plage de 100 kHz à 2000 kHz, de préférence dans la plage de 400 kHz à 1600 kHz, et de manière particulièrement préférée dans la plage de 800 kHz à 1200 kHz.

12. Procédé de revêtement d'une zone de surface d'un substrat (4), dans lequel la zone de surface du substrat (4) est constituée d'un matériau dur, dans lequel le matériau dur contient un liant métallique (6), **caractérisé en ce que** la zone de surface du substrat (4) est préparée pour le revêtement par les deux étapes (1, 2) du procédé selon l'une des revendications 1 à 11 et est revêtue lors d'une troisième étape (3).

13. Procédé selon la revendication 12, **caractérisé en ce que**, lors de la troisième étape (3), la zone de surface du substrat (4) est revêtue d'un revêtement en diamant (8) ou d'un revêtement comportant au moins l'un des éléments Al ou Cr, comme par exemple un revêtement de TiAlN ou un revêtement de TiAlCrN, en particulier un revêtement de carbonitrite comportant au moins l'un des éléments Al ou Cr, comme par exemple un revêtement de TiAlCN ou un revêtement de TiAlCrCN.

14. Procédé de fabrication d'un outil (9) à enlèvement de copeaux, tel qu'une perceuse ou une fraise, dans lequel l'outil (9) comprend un substrat (4), et au moins une zone de surface du substrat (4) est constituée d'un matériau dur et le matériau dur contient un liant métallique (6), **caractérisé en ce qu'**au moins une zone de surface du substrat (4) est revêtue par le procédé selon l'une des revendications 12 ou 13 afin de produire une zone d'enlèvement de copeaux de l'outil (9).
